# EUROPEAN PATENT APPLICATION

(11) **EP 1 991 037 A1**
(43) Date of publication of application: **12.11.2008**
(21) Application number: 06796922.0
(22) Date of filing: 29.08.2006
(51) Int. Cl.: H05H 1/24, C23C 14/32

(54) **PLASMA GUN AND PLASMA GUN FILM FORMING APPARATUS PROVIDED WITH SAME**

(30) Priority: 01.03.2006 JP 2006054603
(71) Applicant: Shinmaywa Industries, Ltd., Takarazuka-shi, Hyogo 665-8550 (JP)
(72) Inventor: MARUNAKA, Masao, c/o Research & Development Center, Takarazuka-shi, Hyogo 665-8550 (JP); TSUCHIYA, Takayuki, c/o Research & Development Center, Takarazuka-shi, Hyogo 665-8550 (JP); TERAKURA, Atsuhiro, c/o Research & Development Center, Takarazuka-shi, Hyogo 665-8550 (JP)
(74) Representative: Piésold, Alexander James
(86) International application number: PCT/JP2006/316942
(87) International publication number: WO 2007/099658

(57) **Abstract**

A plasma gun (1) of the present invention includes: a container (72) having a plasma outflow opening (70); a cathode (18) which is disposed inside the container (72) to generate plasma by discharge; an auxiliary anode (31) which is disposed to be able to be located between the plasma outflow opening (70) and the cathode (18) and is able to receive the plasma generated by the cathode (18); an exhaust valve (26) for exhausting air from and sealing an inside of the container (72); and a plasma flow-out preventing/allowing device (30) which prevents the plasma, having been generated by the discharge of the cathode (18), from flowing out from the plasma outflow opening (70) and allows the plasma to flow out from the plasma outflow opening.

## Description

### Technical Field

The present invention relates to a plasma gun and a plasma gun deposition system including the same.

### Background Art

A plasma deposition system is an apparatus which forms a film by using plasma, generated from a plasma gun, as an ion source. Known as the plasma gun used in such plasma deposition system are a composite cathode type plasma gun, a pressure gradient type plasma gun and a dual type plasma gun that is a combination of the composite cathode type plasma gun and the pressure gradient type plasma gun (see Patent Document 1 for example). Generally, these plasma guns generate plasma using an argon (Ar) gas as a carrier gas. To generate the plasma, glow discharge is carried out by a cathode of the plasma gun, and then shifts to arc discharge. However, the problem is that when using the composite cathode type plasma gun or the dual type plasma gun, the cathode is sputtered by argon ions (Ar⁺) during the glow discharge, and the sputtered metal gets into a deposition chamber and adheres to a substrate, a target etc. on which a film is formed.

To solve such problem, a plasma generating apparatus which uses a hydrogen gas or a helium gas as the carrier gas at the time of the glow discharge is known (see Patent Document 2 for example). Since the plasma generating apparatus of Patent Document 2 uses, for example, gas of hydrogen which is small in mass, it can reduce an etching action caused by the sputtering.
Patent Document 1: Japanese Patent Publication No. 2921874
Patent Document 2: Japanese Laid-Open Patent Application Publication No. Hei. 6-251897

### Disclosure of the Invention

### Problems to be Solved by the Invention

However, in the plasma generating apparatus disclosed in Patent Document 2, when the glow discharge shifts to the arc discharge, the hydrogen gas or the like gradually shifts to the argon gas. Therefore, the sputtering of the cathode occurs. Moreover, if discharge voltage at the time of the glow discharge is high, the etching action caused by the sputtering becomes significant. On this account, there is still room for improvement. Moreover, the problem is that since the hydrogen gas or the like and the argon gas are used, the configuration of the deposition system itself becomes vexatious complication..

The present invention was made to solve the above problems, and an object of the present invention is to provide a plasma gun and a plasma gun deposition system each of which can prevent with a simple configuration, metal, having been sputtered at the time of glow discharge, from flowing out from the plasma gun.

### Means for Solving the Problems

To achieve the above object, a plasma gun according to the present invention includes: a container having a plasma outflow opening; a cathode which is disposed inside the container to generate plasma by discharge; an auxiliary anode which is disposed to be able to be located between the plasma outflow opening and the cathode and is able to receive the plasma generated by the cathode; an exhaust valve for exhausting air from and sealing an inside of the container; and a plasma flow-out preventing/allowing device which prevents the plasma, having been generated by the discharge of the cathode, from flowing out from the plasma outflow opening and allows the plasma to flow out from the plasma outflow opening.

With this, it is possible to prevent metal, having been sputtered at the time of glow discharge, from flowing out from the plasma gun.

In the plasma gun according to the present invention, the plasma flow-out preventing/allowing device may include an opening/closing member capable of opening and closing the plasma outflow opening and a driving device which causes the opening/closing member to open and close, and the auxiliary anode may be formed to be annular.

In the plasma gun according to the present invention, the auxiliary anode may be disposed between the cathode and the opening/closing member.

In the plasma gun according to the present invention, the plasma flow-out preventing/allowing device may include an opening/closing member capable of opening and closing the plasma outflow opening and a driving device which causes the opening/closing member to open and close, and the auxiliary anode may be disposed at the opening/closing member so as to face the cathode in a state where the opening/closing member closes the plasma outflow opening.

The plasma gun according to the present invention may be configured such that: the opening/closing member is configured to move in parallel with an opening surface of the plasma outflow opening to be able to open and close the plasma outflow opening; and the driving device causes the opening/closing member to open and close the plasma outflow opening.

Moreover, a plasma gun deposition system according to the present invention includes: a plasma gun including a container having a plasma outflow opening, a cathode which is disposed inside the container to generate plasma by discharge, and an exhaust valve for exhausting air from and sealing the container; a deposition chamber including a plasma inflow opening and capable of reducing pressure of an inside thereof; an auxiliary anode which is disposed to be able to be located between the plasma inflow opening and the cathode and is able to receive the plasma generated by the cathode; a plasma flow-out preventing/allowing device which prevents the plasma, having been generated by the discharge of the cathode, from flowing in from the plasma inflow opening and allows the plasma to flow in from the plasma inflow opening; and a main anode disposed inside the deposition chamber, wherein: the plasma gun is disposed such that an inside of the container is communicated with the inside of the deposition chamber through the plasma outflow opening and the plasma inflow opening; and the main anode is disposed to be able to receive the plasma, generated by the cathode, in a state where the auxiliary anode does not receive the plasma generated by the cathode, and the plasma flow-out preventing/allowing device allows the plasma to flow in from the plasma inflow opening.

With this, it is possible to prevent the metal, having been sputtered at the time of the glow discharge, from getting into the deposition chamber. Moreover, since the deposition chamber is not contaminated, a film can be uniformly formed on a substrate.

Moreover, the plasma gun deposition system according to the present invention may be configured such that: a substrate holder and a hearth which stores and evaporates a deposition material are disposed inside the deposition chamber; the hearth constitutes the main anode; and the deposition material stored in the hearth is evaporated by the plasma received by the hearth, and is formed into a film on a substrate held by the substrate holder.
Further, a plasma gun deposition system according to the present invention may further include: a sheet plasma deforming chamber disposed between the container and the deposition chamber; and a sheet plasma deforming mechanism, wherein: the sheet plasma deforming chamber is disposed to be communicated with the inside of the deposition chamber via the plasma inflow opening and to be communicated with the inside of the container via the plasma outflow opening; the plasma gun is configured such that columnar plasma is generated in the container and flows out from the plasma outflow opening; the flow-out columnar plasma is deformed into sheet plasma in the sheet plasma deforming chamber by the sheet plasma deforming mechanism; and a film is formed in the deposition chamber by utilizing the sheet plasma flowed from the sheet plasma deforming chamber toward the main anode.
The above object, other objects, features and advantages of the present invention will be made clear by the following detailed explanation of preferred embodiments with reference to the attached drawings.

### Effects of the Invention

In accordance with the plasma gun and plasma gun deposition system of the present invention, it is possible to prevent the metal, having been sputtered at the time of the glow discharge, from the plasma gun, and also possible to uniformly form a film on the substrate since the plasma gun and plasma gun deposition system of the present invention do not contaminate the substrate and the like.

### Brief Description of the Drawings

[Fig. 1] Fig. 1 is a schematic diagram showing the configuration of a plasma gun deposition system according to Embodiment 1 of the present invention.
[Fig. 2] Fig. 2 is a schematic diagram showing a state where an opening/closing member of a plasma flow-out preventing/allowing device of the plasma gun deposition system shown in Fig. 1 is open.
[Fig. 3] Fig. 3 is a schematic diagram showing the configuration of a plasma gun deposition system according to Modification Example 1 of Embodiment 1.
[Fig. 4] Fig. 4 is a schematic diagram showing a state where an opening/closing member of a plasma flow-out preventing/allowing device of the plasma gun deposition system shown in Fig. 3 is open.
[Fig. 5] Fig. 5 is a schematic diagram showing the configuration of a plasma gun deposition system according to Embodiment 2 of the present invention.
[Fig. 6] Fig. 6 is a schematic diagram showing a state where an opening/closing member of a plasma flow-out preventing/allowing device of the plasma gun deposition system shown in Fig. 5 is open.
[Fig. 7] Fig. 7 is a schematic diagram showing the configuration of a plasma gun deposition system according to Modification Example 2 of Embodiment 2.
[Fig. 8] Fig. 8 is a schematic diagram showing a state where an opening/closing member of a plasma flow-out preventing/allowing device of the plasma gun deposition system shown in Fig. 7 is open.

### Explanation of Reference Numbers

- 1: plasma gun
- 2: deposition chamber
- 2a: deposition chamber
- 3: sheet plasma deforming chamber
- 11: tubular body
- 12: discharge space
- 13: lid member
- 14: auxiliary cathode
- 15: protective member
- 16: window member
- 17: main cathode
- 18: cathode
- 19: lid member
- 20: main power supply
- 21: resistor
- 22: grid electrode
- 23: grid electrode
- 24: resistor
- 25: resistor
- 26: exhaust valve
- 27: vacuum pump connecting port
- 28: substrate holder
- 28a: holder portion
- 28b: supporting portion
- 29: magnet coil
- 30: plasma flow-out preventing/allowing device
- 31: opening/closing member
- 32: auxiliary anode
- 34: switch
- 35: chamber
- 35a: ceiling wall
- 36: through hole (plasma inflow opening)
- 37: tubular body
- 37a: lid member
- 37b: lid member
- 38: substrate holder
- 38a: holder portion
- 38b: rotating shaft
- 39: substrate
- 40: hearth (main anode)
- 41: permanent magnet
- 42: supporting body
- 43: deposition material
- 44: exhaust valve
- 45: vacuum pump connecting port
- 46: deposition space
- 47: evaporation source
- 48: bias power supply
- 50: tubular body
- 51: transport space
- 52a: lid member
- 52b: lid member
- 53: permanent magnet
- 54: forming magnet coil
- 55: bottle neck portion
- 56: slit hole
- 57: slit hole (plasma inflow opening)
- 58: bottle neck portion
- 59: tubular body
- 60: target
- 61: target holder
- 61a: holder portion
- 61b: supporting portion
- 62: bias power supply
- 63: magnet coil
- 64: magnet coil
- 65a: lid member
- 65b: lid member
- 66: slit hole
- 67: slit hole
- 68: through hole
- 70: plasma outflow opening
- 71: driving device
- 72: container
- 73a: attaching member
- 73b: attaching member
- 74: anode member
- 75: cooling tube
- 100: plasma gun deposition system
- 101: plasma gun deposition system
- 200: plasma gun deposition system
- 201: plasma gun deposition system
- CP: columnar plasma
- SP: sheet plasma

### Best Mode for Carrying Out the Invention

Hereinafter, preferred embodiments of the present invention will be explained in reference to the drawings.

### Embodiment 1

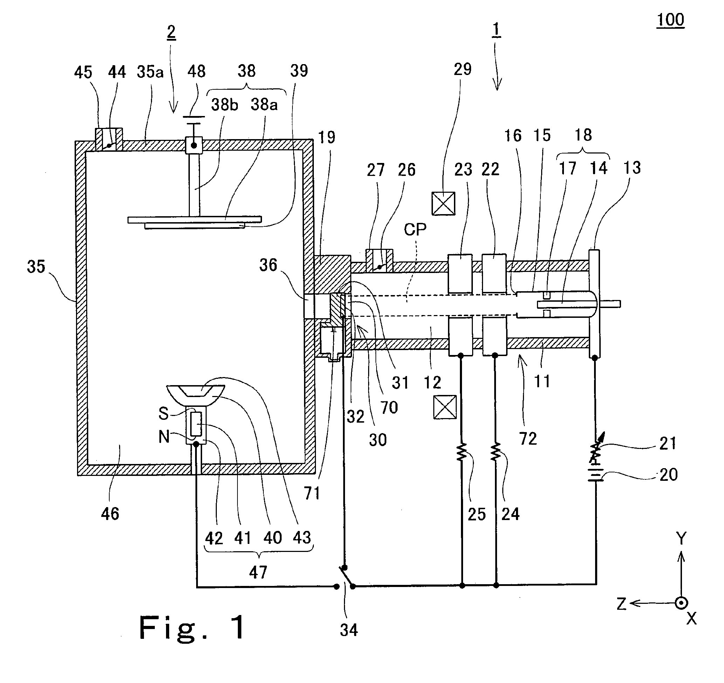

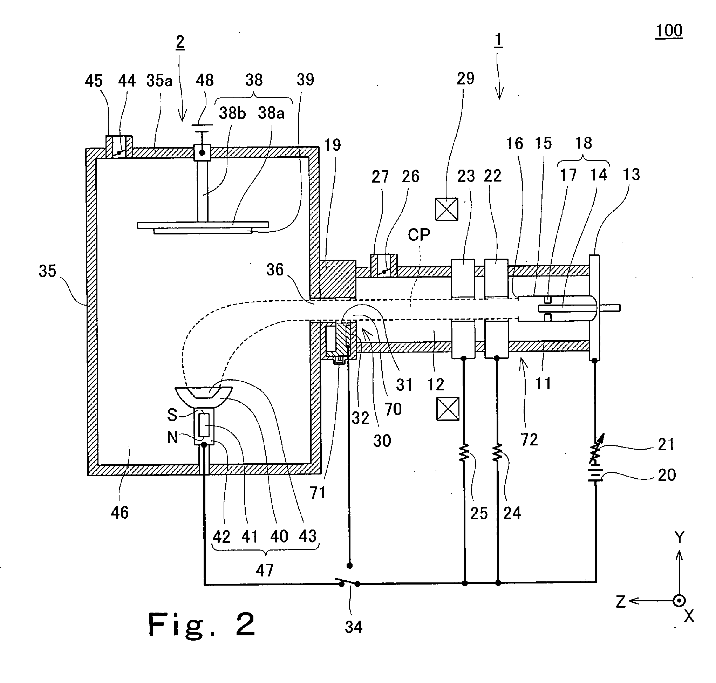

Fig. 1 is a schematic diagram showing the configuration of a plasma gun deposition system according to Embodiment 1 of the present invention. Fig. 2 is a schematic diagram showing a state where an opening/closing member of a plasma flow-out preventing/allowing device of the plasma gun deposition system shown in Fig. 1 is open.

First, the configuration of the plasma gun deposition system according to Embodiment 1 will be explained in reference to Figs. 1 and 2. In the present embodiment, directions in the configuration of the plasma gun deposition system are indicated for convenience by directions of an X-axis, a Y-axis and a Z-axis of a 3-D rectangular coordinate system shown in Figs. 1 and 2.

As shown in Fig. 1, a plasma gun deposition system 100 according to Embodiment 1 includes a dual type plasma gun 1 which generates high-density plasma and a deposition chamber 2 in which a film is formed on a substrate by utilizing the plasma generated by the plasma gun 1. The plasma gun 1 and the deposition chamber 2 are hermetically communicated with each other.

The plasma gun 1 includes a cylindrical tubular body 11. An internal space of the tubular body 11 is a discharge space 12. A plate-like lid member 13 is disposed on one end portion of the tubular body 11 so as to close the discharge space 12. An annular lid member 19 is disposed on the other end portion of the tubular body 11. An internal space of the lid member 19 is a plasma outflow opening 70. The tubular body 11 and the lid members 13 and 19 constitute a container 72.

At the lid member 13, a cylindrical auxiliary cathode 14 made of tantalum (Ta) is disposed to hermetically penetrate a center portion of the lid member 13 and extend along a central axis (Z-axis) of the tubular body 11. A base end (end located outside the tubular body 11) of the auxiliary cathode 14 is connected to an argon (Ar) gas tank (not shown) by a suitable pipe, and an Ar gas is supplied to the discharge space 12 from a tip end of the auxiliary cathode 14. Moreover, an annular main cathode 17 made of lanthanum hexaboride (LaB₆) is disposed in the vicinity of an outer peripheral surface of the tip end of the auxiliary cathode 14. The auxiliary cathode 14 and the main cathode 17 constitute a cathode 18. The cathode 18 is electrically connected to a negative terminal of a main power supply 20, constituted of a DC power supply, via a resistor 21.

In the internal space of the tubular body 11, a cylindrical protective member 15 having a larger diameter than the auxiliary cathode 14 and made of molybdenum (Mo) or tungsten (W) is disposed hermetically with respect to the lid member 13 so as to be coaxial with the auxiliary cathode 14 and to extend along the central axis (Z-axis) of the tubular body 11. An annular window member 16 made of tungsten is disposed on a tip end of the protective member 15. The cathode 18 is protected by the protective member 15 and the window member 16.

The plasma gun 1 includes a pair of annular grid electrodes 22 and 23. The pair of grid electrodes 22 and 23 are disposed to hermetically penetrate the tubular body 11 and are electrically connected to the main power supply 20 and suitable resistors 24 and 25 to receive a predetermined positive voltage between the cathode 18 and the main power supply 20. With this, the arc discharge generated by the cathode 18 is maintained, and plasma constituted of charged particles (here, Ar⁺ and electrons) is generated in the discharge space 12 of the plasma gun 1.

A vacuum pump connecting port 27 which can exhaust air from and seal the inside of the tubular body 11 using an exhaust valve 26 is disposed on a peripheral wall of the other end portion of the tubular body 11. A vacuum pump (not shown; turbopump for example) is connected to the vacuum pump connecting port 27. By vacuuming using the vacuum pump, the discharge space 12 is quickly reduced in pressure to a level that the plasma can be generated. At this time, since air flow in the discharge space 12 is interfered by the grid electrodes 22 and 23, a pressure gradient is generated in the discharge space 12 such that the pressure on the cathode 18 side in the discharge space 12 becomes higher.

Radially outside the tubular body 11, an annular magnet coil 29 capable of controlling the magnitude of the magnetic force is disposed coaxially with the tubular body 11 so as to surround the peripheral wall of the tubular body 11. By supplying current to the magnet coil 29 and applying a predetermined positive voltage to the grid electrodes 22 and 23, a Z-axis-direction gradient of a magnetic flux density based on a coil magnetic field and an electric field generated by the grid electrodes 22 and 23 is generated in the discharge space 12 of the plasma gun 1. By the Z-axis-direction gradient of the magnetic flux density, the charged particles constituting the plasma proceed in the Z-axis direction while circling around the line of magnetic force so as to move in the Z-axis direction from the discharge space. Then, the plasma constituted of the charged particles is drawn to the deposition chamber 2 as cylinder-shape plasma (columnar plasma) CP having a substantially uniform density distribution. The tubular body 11, the grid electrodes 22 and 23 and the cathode 18 are insulated from each other by suitable means.

The shape, height (Y-axis direction dimension) and width (X-axis direction dimension) of the internal space (plasma outflow opening 70) of the lid member 19 are designed to allow the columnar plasma CP to appropriately pass through the lid member 19. With this, it is possible to prevent excessive argon ions (Ar⁺) and electrons, which do not constitute the columnar plasma CP, from being introduced into the deposition chamber 2, so that the density of the columnar plasma CP can be kept high.

A plasma flow-out preventing/allowing device 30 which prevents the plasma from flowing out from the plasma outflow opening 70 and allows the plasma to flow out from the plasma outflow opening 70 is disposed hermetically with respect to the lid member 19. The plasma flow-out preventing/allowing device 30 includes an opening/closing member 31 which opens and closes the plasma outflow opening 70 and a driving device 71 which causes the opening/closing member 31 to move to be in parallel with an opening surface of the plasma outflow opening 70. The opening/closing member 31 is configured to maintain hermetic sealing of the discharge space 12 when it closes the plasma outflow opening 70. Moreover, an auxiliary anode 32 is disposed on an inner surface of the opening/closing member 31 so as to face the cathode 18 when the opening/closing member 31 closes the plasma outflow opening 70. The auxiliary anode 32 is electrically connected to a positive terminal of the main power supply 20 via a switch 34.

With this, in a state where the opening/closing member 31 is closed, and the auxiliary anode 32 and the cathode 18 are connected to each other by the switch 34 (see Fig. 1), regardless of whether or not the deposition chamber 2 is in a vacuum state, the discharge space 12 of the plasma gun 1 can be maintained in the vacuum state, the arc discharge can be generated between the cathode 18 and the auxiliary anode 32, and thus the plasma can be generated. In the present embodiment, the plasma flow-out preventing/allowing device 30 is constituted of a gate valve, the opening/closing member 31 is constituted of a valve body of the gate valve, and the driving device 71 is constituted of a valve body driving device (electromagnetic drive mechanism, air cylinder, or the like) of the gate valve. Fig. 1 shows only an actuator of the valve body driving device constituting the driving device 71.

The deposition chamber 2 includes a chamber 35. An internal space of the chamber 35 forms a deposition space 46. A through hole 36 is formed at an appropriate position of a side wall of the chamber 35 on the plasma gun 1 side. The through hole 36 forms a plasma inflow opening 36. The plasma flow-out preventing/allowing device 30 is disposed to be communicated with the through hole 36 formed on the deposition chamber 2. The shape, etc. of the plasma inflow opening (through hole) 36 are not especially limited as long as the columnar plasma CP can pass through the plasma inflow opening 36, and the plasma gun 1 and the deposition chamber 2 are hermetically communicated with each other via the opening/closing member 31 of the plasma flow-out preventing/allowing device 30. With this, the inside of the container 72 is communicated with the inside of the deposition chamber 2 via the plasma outflow opening 70.

A substrate holder 38 is disposed at an upper portion in the chamber 35. The substrate holder 38 holds a substrate 39. The substrate holder 38 includes a holder portion 38a and a rotating shaft 38b. The rotating shaft 38b hermetically and rotatably penetrates a ceiling wall 35a of the chamber 35, and is connected to and rotated by a rotating mechanism (not shown). Moreover, the substrate holder 38 is electrically connected to a bias power supply 48. The bias power supply 48 applies to the holder portion 38a a negative bias voltage with respect to the columnar plasma CP. The rotating shaft 38b of the substrate holder 38 and the ceiling wall 35a (chamber 35) are connected to each other so as to be insulated from each other.

Moreover, a vacuum pump connecting port 45 which is openable and closable by an exhaust valve 44 is disposed at an appropriate position of the ceiling wall 35a. A vacuum pump (not shown) is connected to the vacuum pump connecting port 45. By vacuuming using the vacuum pump (turbopump for example), the deposition space 46 is quickly reduced in pressure to a level of the degree of vacuum that film formation can be carried out.

Meanwhile, an evaporation source 47 constituted of a hearth 40, a permanent magnet 41 and a supporting body 42 is disposed at a lower portion in the chamber 35. A deposition material 43 is filled in the hearth 40. Moreover, the hearth 40 is supported by the supporting body 42 in which the permanent magnet 41 is disposed, and is electrically connected to the main power supply 20 via the switch 34. With this, the columnar plasma CP having flowed into the deposition chamber 2 curves from the Z-axis direction to the Y-axis direction along the line of magnetic force of the magnetic field generated by the permanent magnet 41, and thus the hearth 40 can receive the plasma as a main anode. The plasma gun deposition system 100 includes a control device (not shown) which controls operations of the entire apparatus.

Next, operations of the plasma gun deposition system 100 according to Embodiment 1 will be explained. The operations are realized by control of the control device (not shown).

First, the driving device 71 of the plasma flow-out preventing/allowing device 30 activates to cause the opening/closing member 31 to close the plasma outflow opening 70. Then, by vacuuming using the vacuum pump (not shown), the inside of the plasma gun 1 and the inside of the deposition chamber 2 become the vacuum state. At this time, due to the grid electrodes 22 and 23, the pressure gradient is generated in the plasma gun 1 (to be precise, in the discharge space 12), that is, the pressure on the cathode 18 side becomes higher in the plasma gun 1. Then, the Ar gas is supplied from the tip end of the auxiliary cathode 14 of the plasma gun 1 into the discharge space 12, and the auxiliary cathode 14 carries out the glow discharge. By the glow discharge, tungsten or the like forming the protective member 15 are sputtered, but the sputtered metal is prevented by the opening/closing member 31 from getting into the deposition chamber 2.

Next, the glow discharge shifts to holocathode discharge at the auxiliary cathode 14. Due to the holocathode discharge, the temperature of the tip end portion of the auxiliary cathode 14 increases, and thus the main cathode 17 is heated and increases in temperature by this heat of the tip end portion of the auxiliary cathode 14. Thereby, the arc discharge is carried out. Thus, plasma discharge induction thermoelectrons are emitted from the cathode 25, and thus the plasma is generated. The generated plasma is drawn from the cathode 18 toward the auxiliary anode 32 by the electric field generated by the grid electrodes 22 and 23 and the magnetic field generated by the magnet coil 29, and is shaped to be columnar. At this time, the auxiliary anode 32 receives the generated plasma.

Next, the driving device 71 activates to cause the opening/closing member 31 to move to be in parallel with the opening surface of the plasma outflow opening 70. Thus, a state of allowing the plasma to flow out from the plasma outflow opening 70 is realized, and the plasma gun 1 and the deposition chamber 2 are communicated with each other. Simultaneously, the switch 34 is switched to allow current to be supplied to the hearth 40 that is the main anode. Thus, the auxiliary anode 32 does not receive the plasma generated by the cathode 18, but the hearth 40 that is the main anode receives the plasma (see Fig. 2). Moreover, the negative bias voltage with respect to the plasma is applied to the substrate 39 via the substrate holder 38. The arc discharge is generated at the hearth 40 that is the main anode receiving the plasma or is generated between the auxiliary anode 32 and the cathode 18.

With this, the shaped columnar plasma CP flows out from the plasma outflow opening 70 and is introduced into the deposition chamber 2 (to be precise, into the deposition space 46). The columnar plasma CP having been introduced into the deposition chamber 2 curves from the Z-axis direction to the Y-axis direction along the line of magnetic force of the magnetic field generated by the permanent magnet 41, and then the hearth 40 receives the columnar plasma CP. By the plasma irradiated onto the hearth 40, the deposition material filled in the hearth 40 evaporates. The evaporated deposition material passes through the plasma in the deposition space 46 and is ionized at this time to be positive ions. The positive ions are deposited on the negatively biased substrate 39, receive the electrons, and are formed into a film on the substrate 39.

With this configuration, it is possible to prevent metal, forming the cathode sputtered at the time of the glow discharge, from getting into the deposition chamber. Moreover, since impurities are prevented from adhering to the substrate and the deposition material, a film can be formed uniformly on the substrate.
Next, a modification example of the plasma gun deposition system according to Embodiment 1 will be explained.

### Modification Example 1

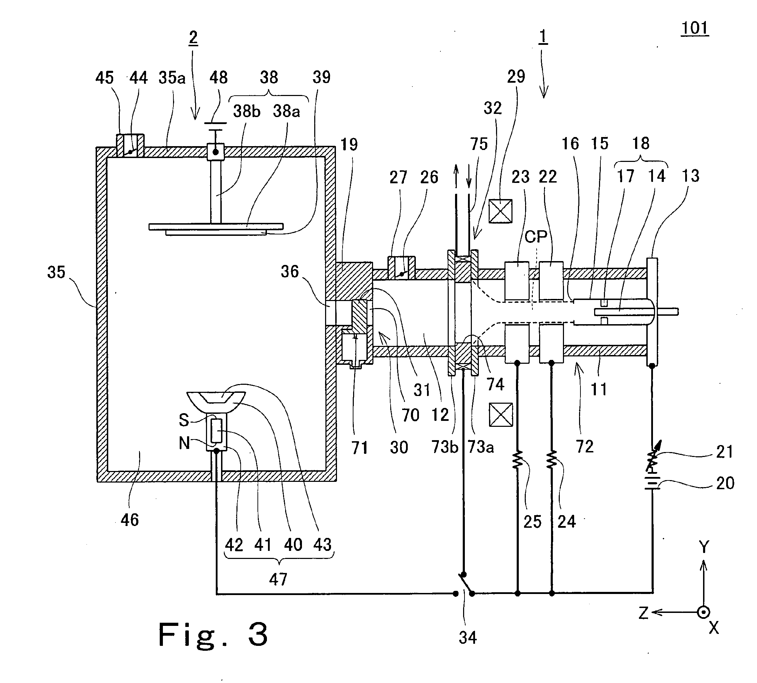

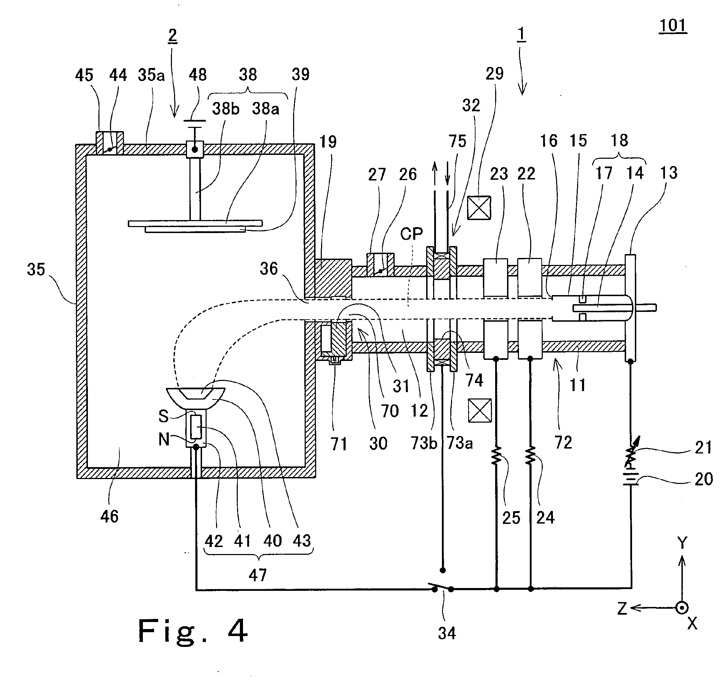

Fig. 3 is a schematic diagram showing the configuration of a plasma gun deposition system according to Modification Example 1. Fig. 4 is a schematic diagram showing a state where the opening/closing member 31 of the plasma flow-out preventing/allowing device 70 of a plasma gun deposition system 101 shown in Fig. 3 is open. In the following explanation, same reference numbers are used for members similar to or corresponding to the members shown in Fig. 1, and a repetition of the same explanation is avoided.

As shown in Fig. 3, in the present modification example, the auxiliary anode 32 shown in Fig. 1 is disposed at an intermediate position of the tubular body 11. The auxiliary anode 32 is configured such that in a case where the auxiliary anode 32 receives the plasma generated by the cathode 17, current is not supplied to the magnet coil 29.

Specifically, the auxiliary anode 32 includes a metal (copper for example) cylindrical anode member 74 disposed coaxially with the tubular body 11. The anode member 74 is hermetically disposed at an appropriate position between the grid electrode 23 of the tubular body 11 and the plasma flow-out preventing/allowing device 30 via cylindrical attaching members 73a and 73b. Moreover, the anode member 74 is electrically connected to the positive terminal of the main power supply 20 via the switch 34. The anode member 74 is insulated from the tubular body 11 by the attaching members 73a and 73b.

Moreover, a metal (copper for example) cooling tube 75 is wound around an outer periphery of the anode member 74 in a circumferential direction of the anode member 74. The cooling tube 75 is configured to be connected to a cooling medium supplying device (not shown) which circulates a cooling medium (herein, water) to cool down the anode member 74.

Next, operations of the plasma gun deposition system 101 according to the present modification example will be explained.
As described above, the glow discharge is carried out at the auxiliary cathode 14, and then the arc discharge is carried out at the main cathode 17, so that the plasma is generated at the cathode 17. The generated plasma is shaped to be columnar by the electric field of the grid electrodes 22 and 23, passes through the internal spaces of the grid electrodes 22 and 23, and is drawn toward the auxiliary anode 32. The columnar plasma CP having passed through the grid electrode 23 spreads toward an inner wall of the tubular body 11 since current is not supplied to the magnet coil 29, and the spread plasma is received by the auxiliary anode 32.
Next, the driving device 71 activates to cause the opening/closing member 31 to move to be in parallel with the opening surface of the plasma outflow opening 70. Thus, a state of allowing the plasma to flow out from the plasma outflow opening 70 is realized, and the plasma gun 1 and the deposition chamber 2 are communicated with each other. Simultaneously, the switch 34 is switched to allow current to be supplied to the hearth 40 that is the main anode. Thus, the auxiliary anode 32 does not receive the plasma generated by the cathode 18, but the hearth 40 that is the main anode receives the plasma.
Simultaneously, the plasma spreading toward the inner wall of the tubular body 11 is shaped to be columnar by supplying current to the magnet coil 29 to apply the magnetic field to the discharge space 12. Then, the columnar plasma CP flows out from the plasma outflow opening 70 and is introduced into the deposition chamber 2 (to be precise, into the deposition space 46). The columnar plasma CP having been introduced into the deposition chamber 2 curves from the Z-axis direction to the Y-axis direction along the line of magnetic force of the magnetic field generated by the permanent magnet 41, and then the hearth 40 receives the columnar plasma CP.
As above, in the plasma gun deposition system according to Modification Example 1, by not supplying current to the magnet coil 29, the columnar plasma CP can spread toward the inner wall of the tubular body 11, and the auxiliary anode 32 can receive the spread plasma.

### Embodiment 2

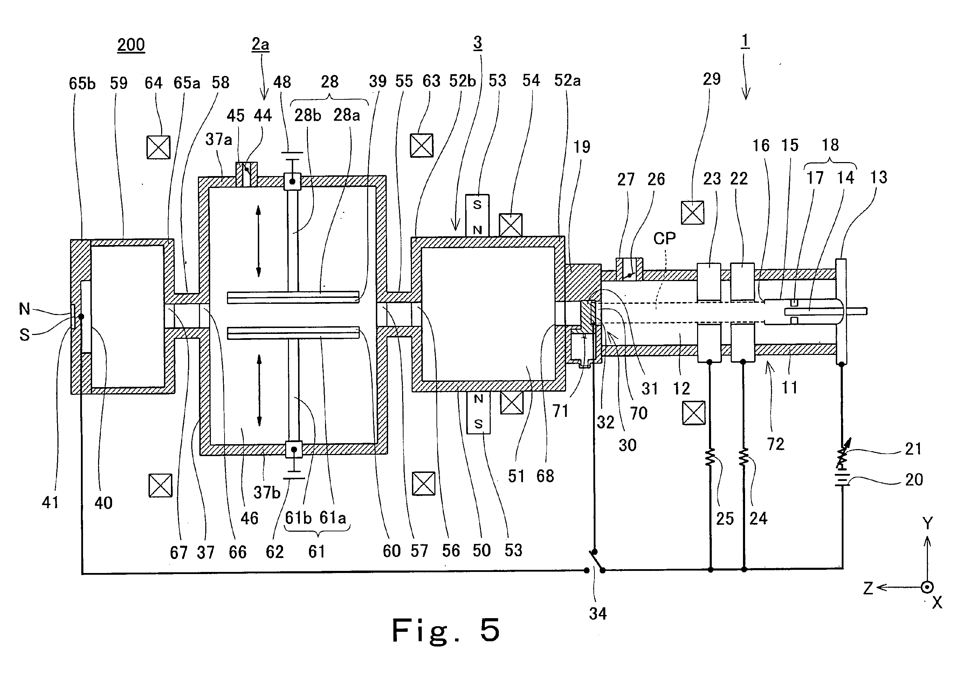

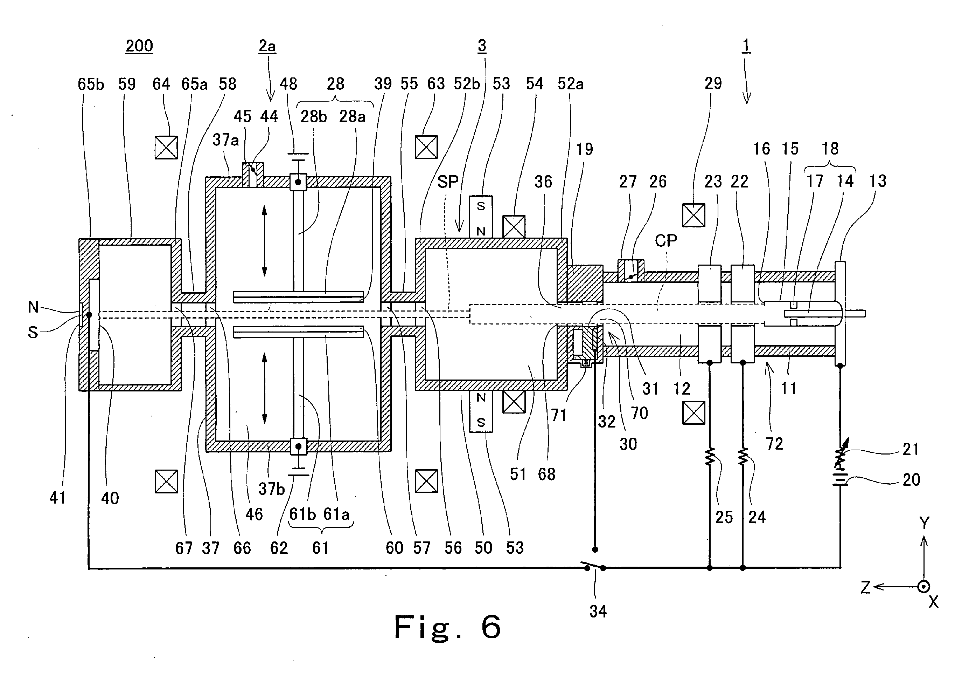

Fig. 5 is a schematic diagram showing the configuration of a plasma gun deposition system 200 according to Embodiment 2 of the present invention. Fig. 6 is a schematic diagram showing a state where the opening/closing member of the plasma flow-out preventing/allowing device of the plasma gun deposition system 200 shown in Fig. 5 is open. In the following explanation, same reference numbers are used for members similar to or corresponding to the members shown in Fig. 1, and a repetition of the same explanation is avoided. Moreover, in the present embodiment, the directions in the configuration of the plasma gun deposition system 200 are indicated for convenience by the directions of the X-axis, Y-axis and Z-axis of the 3-D rectangular coordinate system shown in Figs. 5 and 6.

As shown in Fig. 5, the plasma gun deposition system 200 according to Embodiment 2 has substantially a cross shape on a Y-Z plane and includes the plasma gun 1, a cylindrical nonmagnetic (stainless steel or glass for example) sheet plasma deforming chamber 3 whose center is an axis extending in the Z-axis direction and a cylindrical nonmagnetic (stainless steel for example) deposition chamber 2a whose center is an axis extending in the Y-axis direction, which are arranged in this order when viewed from the Z-axis direction. The plasma gun 1, the sheet plasma deforming chamber 3 and the deposition chamber 2a are hermetically communicated with one another.

The sheet plasma deforming chamber 3 includes a cylindrical tubular body 50. An internal space of the tubular body 50 forms a transport space 51. One (plasma gun 1 side) end portion of the tubular body 50 is closed by a lid member 52a, and the other end portion is closed by a lid member 52b. A through hole 68 is formed at a center portion of the lid member 52a, and the lid member 19 is disposed such that the through hole 68 and the internal space (plasma outflow opening 70) of the lid member 19 are communicated with each other. Moreover, a slit hole 56 is formed at a center portion of the lid member 52b so as to extend in the X-axis direction. The tubular body 50 is hermetically connected to the tubular body 11 by suitable means so as to be electrically insulated from the tubular body 11 and to be coaxial with the tubular body 11 (to share a central axis with the tubular body 11). To easily apply the magnetic force of the permanent magnets 53 or the like to the columnar plasma, the tubular body 50 is made of a nonmagnetic material, such as glass or SUS.

A pair of rectangular permanent magnets 53 are disposed outside the tubular body 50 so as to sandwich the tubular body 50 (to be precise, the transport space 51), to be arranged such that same poles thereof (here, north poles thereof) face each other, to be magnetized in the Y-axis direction, and to extend in the X-axis direction.

Moreover, an annular forming magnet coil 54 (air-core coil) is disposed on the cathode 18 side of the permanent magnets 53 so as to surround a peripheral surface of the tubular body 50. Current flowing in such a direction that the cathode 18 side is the south pole, and the main anode 40 side is the north pole is supplied to the forming magnet coil 54. The permanent magnets 53 and the forming magnet coil 54 constitute a sheet plasma deforming mechanism.

Then, by supplying current to the forming magnet coil 54 and the magnet magnetic field generated in the transport space 51 by the permanent magnets 53, the columnar plasma CP moves in the Z-axis direction in the transport space 51 of the sheet plasma deforming chamber 3 due to an interaction between the coil magnetic field generated in the transport space 51 of the sheet plasma deforming chamber 3. During this time, the columnar plasma CP is deformed into a uniform sheet-shaped plasma (hereinafter referred to as "sheet plasma") SP spreading along the X-Z plane.

The sheet plasma SP having been deformed as above flows into the deposition chamber 2a through a slit-like bottle neck portion 55 formed between the lid member 52b of the tubular body 50 and the side wall of the deposition chamber 2a.

The deposition chamber 2a includes a cylindrical tubular body 37 and a cylindrical tubular body 59 which is communicated with the tubular body 37 via a bottle neck portion 58 and has a central axis extending in the Z-axis direction. An internal space of the tubular body 37 constitutes the deposition space 46. One end portion of the tubular body 37 is closed by a lid member 37a, and the other end portion is closed by a lid member 37b.

A slit hole 57 extending in the X-axis direction is formed on a center portion of a peripheral surface of the tubular body 37 on the tubular body 50 side. The slit hole 57 forms a plasma inflow opening 57. A tubular bottle neck portion 55 having a square cross section is hermetically disposed on the slit hole 57 such that the internal space of the tubular body 37 and the internal space of the tubular body 50 are communicated with each other. The bottle neck portion 55 is hermetically connected to the slit hole 56 formed on the lid member 52b. The height (Y-axis direction dimension), length (Z-axis direction dimension) and width (X-axis direction dimension) of the bottle neck portion 55 are designed to allow the sheet plasma SP to appropriately pass through the bottle neck portion 55. Moreover, each of the widths of the slit holes 56 and 57 may be designed to have a suitable size as long as it is larger than the width of the deformed sheet plasma SP. With this, it is possible to prevent excessive argon ions (Ar⁺) and electrons, which do not constitute the sheet plasma SP, from being introduced into the deposition chamber 2a, so that the density of the sheet plasma SP can be kept high.

In the interior of the tubular body 37, a target 60 as the deposition material and a substrate holder 28 are disposed to sandwich and face the sheet plasma SP. The target 60 is held by a target holder 61, and the target holder 61 includes a holder portion 61a and a supporting portion 61b. The supporting portion 61b is configured to hermetically and slidably penetrate the lid member 37b, to be connected to a drive mechanism (not shown), and to be movable in the Y-axis direction. Moreover, the target holder 61 is electrically connected to a bias power supply 62. The bias power supply 62 applies the negative bias voltage with respect to the sheet plasma SP to the holder portion 61a. The supporting portion 61b of the target holder 61 and the lid member 37b are insulated from each other.
Meanwhile, the substrate holder 28 holds the substrate 39. The substrate holder 28 includes a holder portion 28a and a supporting portion 28b. The supporting portion 28b is configured to hermetically and slidably penetrate the lid member 37a, to be connected to a drive mechanism (not shown), and to be movable in the Y-axis direction. Moreover, the substrate holder 28 is electrically connected to the bias power supply 48. The bias power supply 48 applies the negative bias voltage with respect to the sheet plasma SP to the holder portion 28a. The supporting portion 28b of the substrate holder 28 and the lid member 37a are connected to each other so as to be insulated from each other. Herein, the bias power supply 62 connected to the target holder 61 and the bias power supply 48 connected to the substrate holder 28 are provided separately, but may be configured as a single bias power supply. Further, the target holder 61 and the substrate holder 28 may be configured to be connected to the main power supply 20. However, by disposing separate bias power supplies for the target holder 61 and the substrate holder 28 as described above, it becomes possible to freely set a distance between the target 60 and the substrate 39, and also possible to apply the negative bias voltage to both the target 60 and the substrate 39. As a result, sputtering yield improves.

Moreover, the vacuum pump connecting port 45 which is openable and closable by the exhaust valve 44 is disposed at an appropriate position of the lid member 37a. The vacuum pump (not shown) is connected to the vacuum pump connecting port 45. By vacuuming using the vacuum pump (turbopump for example), the deposition space 46 is quickly reduced in pressure to a level of the degree of vacuum that a sputtering process can be carried out.

A pair of magnet coils 63 and 64 capable of controlling the magnitude of the magnetic force are disposed outside the tubular body 37 so as to penetrate central axes of the tubular bodies 11 and 50. The magnet coils 63 and 64 are disposed such that different poles thereof face each other (herein, the north pole of the magnet coil 63 and the south pole of the magnet coil 64 face each other).

By the coil magnetic field (about 10G to 300G for example) generated by supplying current to the magnet coils 63 and 64, the shape of the sheet plasma SP in the width direction (X-axis direction) is shaped so that the diffusion in the width direction is appropriately suppressed by a mirror magnetic field while the sheet plasma SP moves in the Z-axis direction so as to go through the deposition space 51 of the deposition chamber 3.

Moreover, the deposition chamber 2a includes the tubular body 59 which is communicated with the tubular body 37 via the bottle neck portion 58 and has a central axis extending in the Z-axis direction. One (tubular body 37 side) end portion of the tubular body 59 is closed by a lid member 65a, and the other end portion is closed by a lid member 65b. A slit hole 67 extending in the X-axis direction is formed at a center portion of the lid member 65a. The tubular bottle neck portion 58 having a square cross section is hermetically disposed on the slit hole 67 such that the internal space of the tubular body 59 and the internal space of the tubular body 37 are communicated with each other. The bottle neck portion 58 is hermetically connected to a slit hole 66 which is formed at a center portion of the peripheral surface of the tubular body 37 so as to extend in the X-axis direction. As with the bottle neck portion 55, the height (Y-axis direction dimension), length (Z-axis direction dimension) and width (X-axis direction dimension) of the bottle neck portion 58 are designed to allow the sheet plasma SP to appropriately pass through the bottle neck portion 58. Moreover, the height and width of the slit holes 66 and 67 are formed to be the same as those of the slit holes 56 and 57 described above.

The main anode 40 is disposed on an inner surface of the lid member 65b and is electrically connected to the positive terminal of the main power supply 20 via the switch 34. A suitable positive voltage (100V for example) is applied between the cathode 18 and the main anode 40 by the main power supply 20. With this, the cathode 18 can collect charged particles (especially, electrons) in the sheet plasma SP by the arc discharge between the main anode 40 and the cathode 18.

The permanent magnet 41 is disposed on a rear surface (surface opposite the surface facing the cathode 18) of the main anode 40 such that the south pole faces the main anode 40, and the north pole faces the air. With this, by the line of magnetic force which is emitted from the north pole of the permanent magnet 41 and enters into the south pole along the X-Z plane, the sheet plasma SP converges in the width direction such that the diffusion of the sheet plasma SP proceeding toward the main anode 40 is suppressed in the width direction (X-axis direction), and the charged particles of the sheet plasma SP are appropriately collected by the main anode 40.

To obtain effects of the present invention, the plasma flow-out preventing/allowing device 30 may be disposed at the sheet plasma deforming chamber 3 (to be precise, at the bottle neck portion 55). Moreover, a cross section of each of the tubular body 11, the tubular body 50 and the tubular body 59 which section is in parallel with the X-Y plane is circular but is not limited to this, and may be polygonal or the like. Moreover, a cross section of the tubular body 37 which section is in parallel with the X-Z plane is circular but is not limited to this, and may be polygonal or the like.

Next, operations of the plasma gun deposition system 200 according to Embodiment 2 will be explained.

First, the columnar plasma CP is generated in the same manner as the operations of the plasma gun deposition system 100 according to Embodiment 1. The generated columnar plasma CP is introduced into the sheet plasma deforming chamber 3 along the line of magnetic force of the magnetic field generated by the magnet coil 29.
The columnar plasma CP having been introduced into the sheet plasma deforming chamber 3 spreads due to the magnetic field generated by a pair of permanent magnets 53 and the forming magnet coil 54 so as to have a sheet shape (to spread along the X-Z plane). Thus, the columnar plasma CP is deformed into the sheet plasma SP. The sheet plasma SP passes through the slit hole 56, the bottle neck portion 55 and the slit hole 57 and then is introduced into the deposition chamber 2a.

The sheet plasma SP having been introduced into the deposition chamber 2a is shaped in the width direction by the magnetic field generated by the magnet coils 63 and 64, and then is introduced into a space between the target 60 and the substrate 39. The negative bias voltage with respect to the sheet plasma SP is applied to the target 60 via the target holder 61. Moreover, the negative bias voltage with respect to the sheet plasma SP is applied to the substrate 39 via the substrate holder 28. By negatively biasing the target 60, the Ar⁺ ions effectively sputter the target. Atoms constituting the sputtered target 60 pass through the sheet plasma SP in the vertical direction, and are ionized at this time to be positive ions. The positive ions are deposited on the negatively biased substrate 39, receive the electrons, and are formed into a film on the substrate 39.
Then, the sheet plasma SP converges in the width direction by the line of magnetic force generated by the permanent magnet 41, and the main anode 40 receives the sheet plasma SP.

With this configuration, it is possible to prevent the metal, forming the cathode sputtered at the time of the glow discharge, from getting into the deposition chamber. Moreover, since impurities are prevented from adhering to the substrate and the deposition material, a film can be formed uniformly on the substrate.

Next, a modification example of the plasma gun deposition system according to Embodiment 2 will be explained.

### Modification Example 2

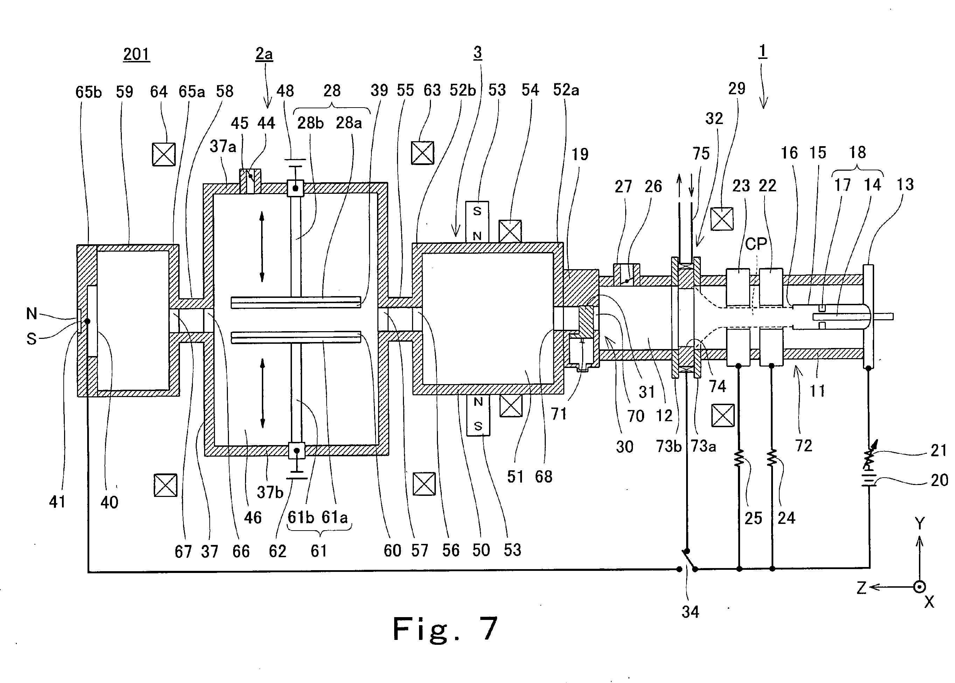

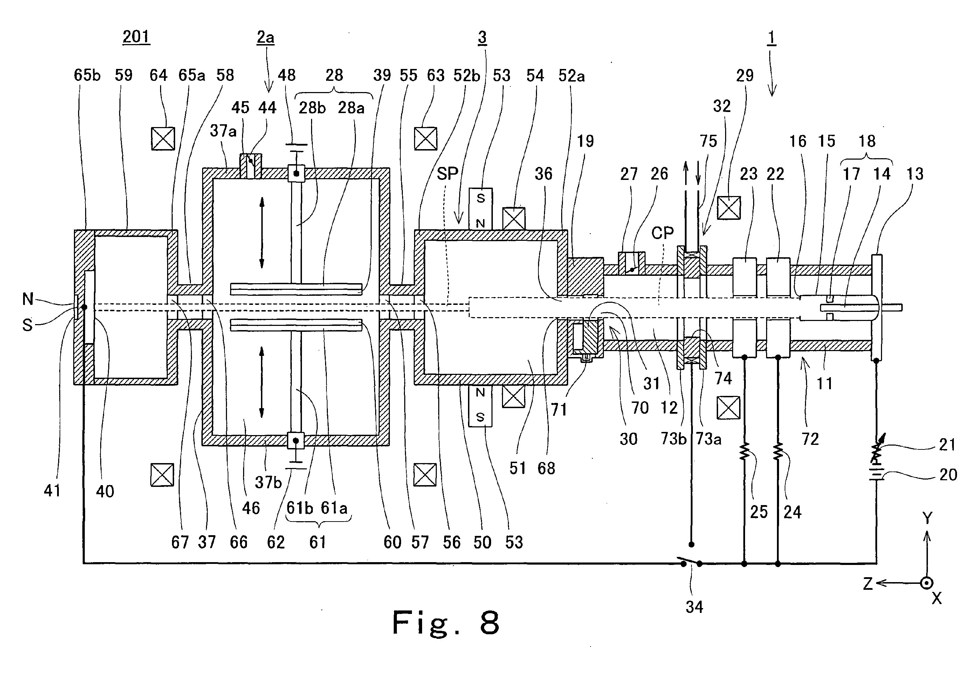

Fig. 7 is a schematic diagram showing the configuration of a plasma gun deposition system according to Modification Example 2. Fig. 8 is a schematic diagram showing a state where the opening/closing member 31 of the plasma flow-out preventing/allowing device 70 of a plasma gun deposition system 201 shown in Fig. 7 is open. In the following explanation, same reference numbers are used for members similar to or corresponding to the members shown in Fig. 5, and a repetition of the same explanation is avoided.

As shown in Fig. 7, in the present modification example, the auxiliary anode 32 shown in Fig. 5 is disposed at a halfway portion of the tubular body 11. The auxiliary anode 32 is configured such that in a case where the auxiliary anode 32 receives the plasma generated by the cathode 17, current is not supplied to the magnet coil 29, 63 or 64 or the forming magnet coil 54.
Specifically, the auxiliary anode 32 includes a metal (copper for example) cylindrical anode member 74 disposed coaxially with the tubular body 11. The anode member 74 is hermetically disposed at an appropriate position between the grid electrode 23 of the tubular body 11 and the plasma flow-out preventing/allowing device 30 via the cylindrical attaching members 73a and 73b. Moreover, the anode member 74 is electrically connected to the positive terminal of the main power supply 20 via the switch 34. The anode member 74 is insulated from the tubular body 11 by the attaching members 73a and 73b.

Moreover, the metal-made (copper for example) cooling tube 75 is wound around the outer periphery of the anode member 74 in a circumferential direction of the anode member 74. The cooling tube 75 is configured to be connected to the cooling medium supplying device (not shown) which circulates the cooling medium (here, water) to cool down the anode member 74.

Next, operations of the plasma gun deposition system 201 according to the present modification example will be explained.
As described above, the glow discharge is carried out at the auxiliary cathode 14, and then the arc discharge is carried out at the main cathode 17, so that the plasma is generated at the cathode 17. The generated plasma is shaped to be columnar due to the electric field of the grid electrodes 22 and 23, passes through the internal spaces of the grid electrodes 22 and 23, and is drawn toward the auxiliary anode 32. The columnar plasma CP having passed through the grid electrode 23 spreads toward the inner wall of the tubular body 11 since current is not supplied to the magnet coil 29, 63 or 64 or the forming magnet coil 54, and the spread plasma is received by the auxiliary anode 32. In order to avoid that the plasma generated by the cathode 17 is shaped to be columnar, current may not be supplied only to the magnet coil 29.
Next, the driving device 71 activates to cause the opening/closing member 31 to move to be in parallel with the opening surface of the plasma outflow opening 70. Thus, a state of allowing the plasma to flow out from the plasma outflow opening 70 is realized, and the plasma gun 1 and the sheet plasma deforming chamber 3 are communicated with each other. Simultaneously, the switch 34 is switched to allow current to be supplied to the main anode 40. Thus, the auxiliary anode 32 does not receive the plasma generated by the cathode 18, but the main anode 40 receives the plasma (see Fig. 8). Simultaneously, the plasma spreading toward the inner wall of the tubular body 11 is shaped to be columnar by supplying current to the magnet coils 29, 63 and 64 and the forming magnet coil 54 to apply the magnetic field to the discharge space 12 or the like. Then, the columnar plasma CP flows out from the plasma outflow opening 70 and is introduced into the sheet plasma deforming chamber 3 (to be precise, into the transport space 51). The columnar plasma CP having been introduced into the sheet plasma deforming chamber 3 is deformed into the sheet plasma SP due to the interaction between the coil magnetic field generated by the forming magnet coil and the magnet magnetic field generated by the permanent magnets 53, and then the sheet plasma SP is introduced into the deposition chamber 2a. The sheet plasma SP having been introduced into the deposition chamber 2a is shaped by the coil magnetic field generated by the magnet coils 63 and 64, and the main anode 40 receives the sheet plasma SP.
As above, in the plasma gun deposition system according to Modification Example 2, by not supplying current to the magnet coil 29, 63 or 64 or the forming magnet coil 54, the columnar plasma CP can spread toward the inner wall of the tubular body 11, and the auxiliary anode 32 can receive the spread plasma.
In the embodiments of the present invention, the film formation is carried out in a state where the vacuum state is realized in the plasma deposition system. However, the film formation may be carried out in a state where a reactive gas is introduced into the deposition chamber, and the substrate is formed using a reactant obtained from the gas and the deposition material.
Moreover, the plasma flow-out preventing/allowing device may open and close the plasma outflow opening by causing the opening/closing member to swing.
From the foregoing explanation, many modifications and other embodiments of the present invention are obvious to one skilled in the art. Therefore, the foregoing explanation should be interpreted only as an example, and is provided for the purpose of teaching the best mode for carrying out the present invention to one skilled in the art. The structures and/or functional details may be substantially modified within the spirit of the present invention.

### Industrial Applicability

A plasma gun and plasma gun deposition system of the present invention are useful since it is possible to prevent impurities from getting into a deposition chamber. Moreover, since the deposition chamber and the plasma gun can be separately reduced in pressure, the plasma gun and the plasma gun deposition system are useful as a gun and apparatus each of which can operate at atmospheric pressure in the deposition chamber in a state where the plasma gun is generating plasma or can replace the plasma gun in a state where the inside of the deposition chamber is being kept in a vacuum state.

## Claims

1. A plasma gun comprising:
a container having a plasma outflow opening;
a cathode which is disposed inside the container to generate plasma by discharge;
an auxiliary anode which is disposed to be able to be located between the plasma outflow opening and the cathode and is able to receive the plasma generated by the cathode;
an exhaust valve for exhausting air from and sealing an inside of the container; and
a plasma flow-out preventing/allowing device which prevents the plasma, having been generated by the discharge of the cathode, from flowing out from the plasma outflow opening and allows the plasma to flow out from the plasma outflow opening.

2. The plasma gun according to claim 1, wherein:
the plasma flow-out preventing/allowing device includes an opening/closing member capable of opening and closing the plasma outflow opening and a driving device which causes the opening/closing member to open and close, and
the auxiliary anode is formed to be annular.

3. The plasma gun according to claim 2, wherein the auxiliary anode is disposed between the cathode and the opening/closing member.

4. The plasma gun according to claim 1, wherein:
the plasma flow-out preventing/allowing device includes an opening/closing member capable of opening and closing the plasma outflow opening and a driving device which causes the opening/closing member to open and close, and
the auxiliary anode is disposed at the opening/closing member so as to face the cathode in a state where the opening/closing member closes the plasma outflow opening.

5. The plasma gun according to any one of claims 2 to 4, wherein:
the opening/closing member is configured to move in parallel with an opening surface of the plasma outflow opening to be able to open and close the plasma outflow opening; and
the driving device causes the opening/closing member to open and close the plasma outflow opening.

6. A plasma gun deposition system comprising:
a plasma gun including a container having a plasma outflow opening, a cathode which is disposed inside the container to generate plasma by discharge, and an exhaust valve for exhausting air from and sealing the container;
a deposition chamber including a plasma inflow opening and capable of reducing pressure of an inside thereof;
an auxiliary anode which is disposed to be able to be located between the plasma inflow opening and the cathode and is able to receive the plasma generated by the cathode;
a plasma flow-out preventing/allowing device which prevents the plasma, having been generated by the discharge of the cathode, from flowing in from the plasma inflow opening and allows the plasma to flow in from the plasma inflow opening; and
a main anode disposed inside the deposition chamber, wherein:
the plasma gun is disposed such that an inside of the container is communicated with the inside of the deposition chamber through the plasma outflow opening and the plasma inflow opening; and
the main anode is disposed to be able to receive the plasma, generated by the cathode, in a state where the auxiliary anode does not receive the plasma generated by the cathode, and the plasma flow-out preventing/allowing device allows the plasma to flow in from the plasma inflow opening.

7. The plasma gun deposition system according to claim 6, wherein:
a substrate holder and a hearth which stores and vaporizes a deposition material are disposed inside the deposition chamber;
the hearth constitutes the main anode; and
the deposition material stored in the hearth is vaporized by the plasma received by the hearth, and is formed into a film on a substrate held by the substrate holder.

8. The plasma gun deposition system according to claim 6, further comprising:
a sheet plasma deforming chamber disposed between the container and the deposition chamber; and
a sheet plasma deforming mechanism, wherein:
the sheet plasma deforming chamber is disposed to be communicated with the inside of the deposition chamber via the plasma inflow opening and to be communicated with the inside of the container via the plasma outflow opening;
the plasma gun is configured such that columnar plasma is generated in the container and flows out from the plasma outflow opening;
the flow-out columnar plasma is deformed into sheet plasma in the sheet plasma deforming chamber by the sheet plasma deforming mechanism; and
a film is formed in the deposition chamber by utilizing the sheet plasma flowed from the sheet plasma deforming chamber toward the main anode.
